Europäisches Patentamt

European Patent Office

Office européen des brevets

(19)

(11) Publication number: **0 248 521**
**A2**

# (12) EUROPEAN PATENT APPLICATION

(21) Application number: 87303609.9

(51) Int. Cl.4: **G01R 1/073**

(22) Date of filing: 24.04.87

The title of the invention has been amended (Guidelines for Examination in the EPO, A-III, 7.3).

(30) Priority: 25.04.86 GB 8610117

(43) Date of publication of application:
**09.12.87 Bulletin 87/50**

(84) Designated Contracting States:
**DE FR IT NL**

(71) Applicant: **PLESSEY OVERSEAS LIMITED**
**Vicarage Lane**
**Ilford Essex IGI 4AQ(GB)**

(72) Inventor: **Saunders, David Christopher**
**1 Roberts Close Wroughton**
**Swindon Wiltshire SN4 0RS(GB)**

(74) Representative: **Nicholson, Ronald et al**
**Intellectual Property Department The**
**Plessey Company plc 2-60 Vicarage Lane**
**Ilford Essex IG1 4AQ(GB)**

(54) **Electrical contactors.**

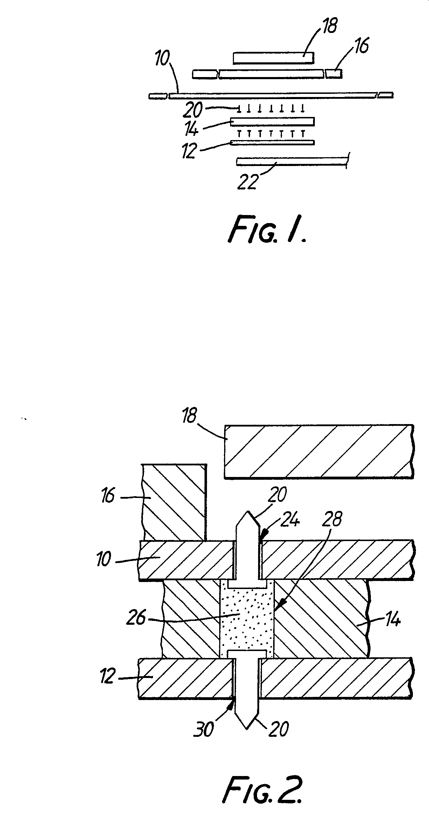

(57) An electrical contactor for (fig 2) testing high frequency integrated circuits including a centre plate (14) with resilient conductive paths (26) therethrough and upper and lower plates (10, 12) with contact pins (20) aligned with the conductive paths (26) to contact an integrated circuit (18) to be tested and a test board (22). The resilient conductive paths (26) may be provided eg by pads of metal impregnated silicon rubber or by phosphor-bronze wool inserts.

EP 0 248 521 A2

## IMPROVEMENTS IN OR RELATING TO ELECTRICAL CONTACTORS

The present invention relates to electrical contactors and more particularly to contactor assemblies for the testing of high frequency integrated circuits.

A known contactor assembly comprises a plurality of spring loaded pins which provide a contact between a required point on a printed circuit board and a test lead. A disadvantage with this type of contactor assembly is that coil springs provide a relatively high electrical inductance and at high frequencies this produces errors in the test results.

It is an object of the present invention to provide a contactor assembly for testing integrated circuits which does not have any elements which introduce any substantial high frequency errors into the test results.

According to the present invention there is provided an electrical contactor for high frequency integrated circuits including a first plate, a second plate with a centre plate sandwiched between, the first plate and the second plate being provided with through holes corresponding in position to points to be tested on an integrated circuit to be tested and in which the centre plate includes a plurality of isolated conductive regions of resilient conductive material in positions within the centre plate corresponding to the through holes in the first and second plates, a plurality of conductive pins being provided through the through holes in the first and second plates to provide the contacts to the integrated circuit to be tested.

Preferably the resilient conductive material is a metal loaded silicon rubber or a metallic wool such as phosphor bronze wire "fuzz". In a prefered embodiment the isolated conductive regions are positioned within through holes in the centre plate, which holes are plated with a conductive material to improve the conductivity of the regions.

Preferably the first second and centre plates are formed in ceramic material the holes being accurately drilled or spark eroded therethrough.

The assembly is preferably accurately held by a guide ring adjacent the first plate, the guide ring forming a positional guide for an integrated circuit to be tested.

Embodiments of the present invention will now be described, by way of example, with reference to the accompanying drawings, in which:-

Figure I shows in elevation an exploded view of the contactor assembly according to the present invention;

Figure 2 shows in cross sectional elevation a detail showing one of the plurality of contacts of the contactor assembly of figure I; and,

With reference now to figure I, the contactor assembly comprises a first plate I0 and a second plate I2 with a centre plate I4 sandwiched between. A guide ring plate I6 is positioned above the first plate I0 and serves to guide the positioning of an integrated circuit I8 to be tested. A plurality of pins 20 are provided on both sides of the centre plate I4. In use a base plate 22 equipped with suitable tracking provides electrical contact for the low pins 20 which protude through the lower plate I2. Suitable test gear (not shown) may be connected to the base plate 22.

With reference to figure 2 the first plate I0 is provided with a plurality of through holes 24 which align with conductive resilient conductive medium pads 26 which fill holes 28 in the centre plate I4. The holes 28 align with holes 30 in the second (bottom) plate I2 through which the lower pins 20 pass.

A conductive path is formed by upper and lower pins 20 and the medium 26, which path is relatively non inductive and thereby does not affect the test results of a high frequency integrated circuit.

The conducting medium 26 may be constructed from a metal loaded silicon rubber or phosphor bronze wire "fuzz" and the pins are of a suitable conductive metal shaped to provide a good contact on the medium 26 by having a flat base and a pointed end to give good electrical contact with an integrated circuit.

The integrated circuit to be tested is placed within the guide ring I6 and pressed onto the upper pins 20 whilst the test sequence is carried out.

The holes 24, 28 and 30 are in alignment.

The plate thicknesses are in a practical embodiment as follows:-

plate I6-0.040 to 0.050 inches (I000 to I300 micron) thick

plate I0 - 0.025 inches (600 micron) thick

plate I4 - 0.050 inches (I300 micron) thick

plate I2 - 0.025 inches (600 micron) thick

The holes 28 may be through plated with a conductive medium to provide an extra conductive path thereby lowering the resistance of the contact.

## Claims

I. An electrical contactor for high frequency integrated circuits including a first plate, a second plate with a centre plate sandwiched therebetween, the first plate and the second plate being provided with through holes corresponding in position to points to be tested on an integrated circuit to be tested and in which the centre plate includes a plurality of isolated conductive regions of resilient conductive material in positions within the centre plate corresponding to the through holes in the first and second plates, a plurality of conductive pins being provided through the through holes in the first and second plates to provide contacts to the integrated circuit to be tested.

2. An electrical contactor as claimed in claim I in which the resilient conductive material is a metal loaded silicon rubber or a phosphor-bronze wire fuzz.

3. An electrical contactor as claimed in claim I or claim 2 in which the isolated conductive regions are positioned within through holes in the centre plate, which holes are plated with a conductive material to improve the conductivity of the regions.

4. An electrical contactor as claimed in any one of the preceding claims in which the first, second and centre plates are formed in ceramic material, the through holes being accurately drilled or spark eroded therethrough.

5. An electrical contactor as claimed in any one of the preceding claims including a guide ring positioned adjacent the first plate, the guide ring forming a positional guide for an integrated circuit to be tested.

FIG. I.

FIG. 2.